# EUROPEAN PATENT APPLICATION

(11) **EP 3 306 660 A2**
(43) Date of publication of application: **11.04.2018**
(21) Application number: 17184584.5
(22) Date of filing: 02.08.2017
(51) Int. Cl.: H01L 23/495, H01L 23/31

(54) **LEADFRAME-LESS SURFACE MOUNT SEMICONDUCTOR DEVICE**

(30) Priority: 06.10.2016 US 201615287584
(71) Applicant: Nexperia B.V., 6534 AB Nijmegen (NL)
(72) Inventor: Santos, Eugene Pumanes, 6534 AB Nijmegan (NL); Umali, Pompeo v., 6534 AB Nijmegan (NL)
(74) Representative: Crawford, Andrew

(57) **Abstract**

A semiconductor device includes a semiconductor die having a top surface with bond pads formed thereon, electrical connection elements each having a first end located at a first plane and electrically connected to one of the bond pads, and an opposite second end located at a second plane that is different from the first plane, and a molding material encapsulating the semiconductor die and the electrical connection elements, wherein the molding material defines a package body that has a top surface and one or more side surfaces, wherein the second end of each electrical connection element is exposed at the top surface and at least one of the one or more side surfaces of the package body.

## Description

### BACKGROUND

The present invention relates to integrated circuit (IC) device assembly and, more particularly, to a leadframe-less surface mount semiconductor device.

A Quad Flat No-leads (QFN) package made with a planar copper lead frame is a widely used surface-mount technology. A typical QFN assembly flow includes Front of Line (FOL) and End of Line (EOL) processes. The FOL processes include die bonding, interconnect bonding, and inspection, and the EOL processes include molding, top marking, Sn plating, package singulation, and final inspection, which is a costly packaging process. Accordingly, it would be advantageous to have a leadframe-less package construction to improve the assembly processes and reduce the total packaging cost.

### BRIEF DESCRIPTION OF THE DRAWINGS

The invention, together with objects and advantages thereof, may best be understood by reference to the following description of preferred embodiments together with the accompanying drawings in which:
FIG. 1A is a partially exploded isometric view of a leadframe-less surface mount semiconductor device in accordance with a first embodiment of the present invention, and FIGS. 1B and 1C are cross-sectional side views of the device of FIG. 1A from sides A and B;
FIG. 2 is a partially exploded isometric view of a leadframe-less surface mount semiconductor device in accordance with a second embodiment of the present invention;
FIG. 3 is a partially exploded isometric view of a leadframe-less surface mount semiconductor device in accordance with a third embodiment of the present invention; and
FIGS. 4A-4B, 5A-5B, 6A-6B, 7-8, 9A-9B, 10, 11A-11B and 12-13 are a series of diagrams illustrating steps in assembling a leadframe-less surface mount semiconductor in accordance with an embodiment of the present invention.

### DETAILED DESCRIPTION OF PREFERRED EMBODIMENTS

The detailed description set forth below in connection with the appended drawings is intended as a description of presently preferred embodiments of the invention, and is not intended to represent the only forms in which the present invention may be practised. It is to be understood that the same or equivalent functions may be accomplished by different embodiments that are intended to be encompassed within the spirit and scope of the invention. In the drawings, like numerals are used to indicate like elements throughout. It also should be noted that the drawings provide enlarged views and may not be drawn to scale so that particular features of the invention may be better understood. The terms "comprises," "comprising," or any variations thereof, are intended to cover a non-exclusive inclusion, such that module, circuit, device components, structures and method steps that comprises a list of elements or steps does not include only those elements but may include other elements or steps not expressly listed or inherent to such module, circuit, device components or steps. An element or step proceeded by "comprises ... a" does not, without more constraints, preclude the existence of additional identical elements or steps that comprises the element or step.

In one embodiment, the present invention provides a semiconductor device including a semiconductor die having a top surface with one or more bond pads formed thereon, and one or more electrical connection elements each having a first end located at a first plane and electrically connected to one of the bond pads, and an opposite second end located at a second plane that is different from the first plane. A molding material encapsulates the semiconductor die and the electrical connection elements. The molding material defines a package body that has a top surface and one or more side surfaces. The second end of each electrical connection element is exposed at the top surface and at least one of the side surfaces of the package body.

In another embodiment, the present invention provides a method for assembling a semiconductor device. The method includes providing a wafer that has a top surface and an opposite bottom surface, a plurality of semiconductor dies arranged in an array that extends in first and second directions, and saw streets located between adjacent ones of the semiconductor dies. Each semiconductor die has one or more bond pads formed on the top surface. The method also includes bonding one or more electrical connection elements to the bond pads of the semiconductor dies, wherein each electrical connection element bridges adjacent semiconductor dies in at least one of the first and second directions, and encapsulating the semiconductor dies and the electrical connection elements with a molding material to form an assembly of an array of semiconductor devices. Each semiconductor device comprises a package body formed by the molding material, and each of the one or more electrical connection elements has a bridge portion exposed at a top surface of the assembly. The method further includes singulating the semiconductor devices by cutting the assembly along the saw streets, wherein a remaining portion of each electrical connection element of each semiconductor device has an end exposed at a top surface and at least one side surface of the package body.

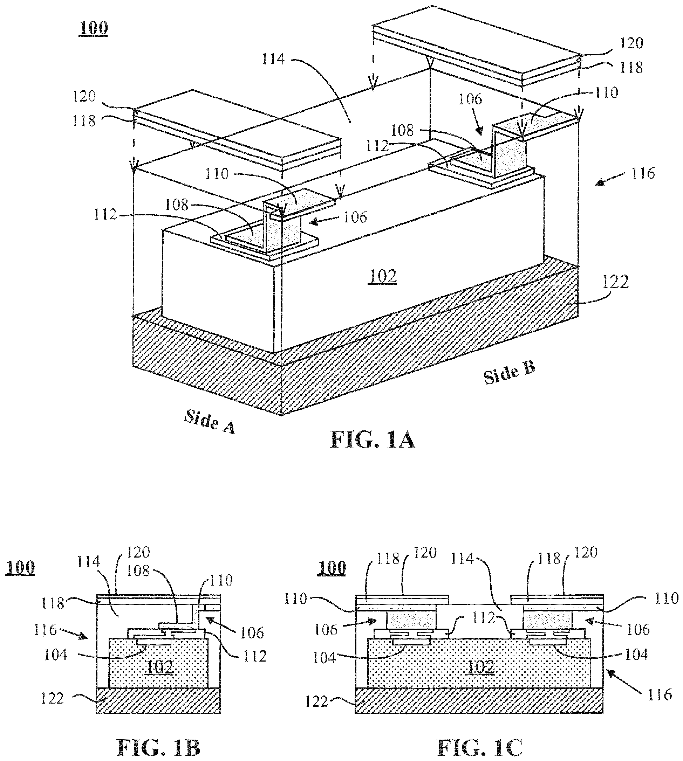

Referring now to FIGS. 1A-1C, an example of a leadframe-less surface mount semiconductor device 100 is shown. In particular, FIG. 1A shows a partially exploded isometric view of the leadframe-less surface mount semiconductor device 100, and FIGS. 1B and 1C are cross-sectional side views of the leadframe-less surface mount semiconductor device of FIG. 1A from sides A and B. The semiconductor device 100 includes a semiconductor die 102 having a top surface with one or more bond pads 104 formed thereon, and one or more electrical connection elements 106 each having a first end 108 located at a first plane and electrically connected to one of the one or more bond pads 104, and an opposite second end 110 located at a second plane that is different from the first plane.

In a preferred embodiment, the first end 108 of the electrical connection element 106 is bonded directly to the bond pad 104. In another preferred embodiment, the semiconductor device 100 includes an optional redistribution layer 112 located between the bond pad 104 and the first end 108 of the electrical connection element 106.

The semiconductor device 100 further includes a molding material 114 that covers or encapsulates the semiconductor die 102 and the one or more electrical connection elements 104. The molding material 114 defines a package body 116 that has a top surface and one or more side surfaces. The second end 110 of each electrical connection element 106 is exposed at the top surface and at least one of the one or more side surfaces of the package body 116. In a preferred embodiment, the electrical connection element 106 is a conductive clip formed from copper that may be plated or unplated. The second end 110 of each electrical connection element 106 is exposed at the top surface and two adjacent side surfaces of the package body 116.

In a preferred embodiment, the semiconductor device 100 includes a metal layer 118 formed over the top surface of the package body 116 and electrically connected to the second end 110 of each electrical connection element 106. In a preferred embodiment, the metal layer 118 comprises copper or another conductive metal. In another preferred embodiment, the metal layer 118 is coated with a wettable material 120, such as tin, using an electrically conductive plating process.

In a preferred embodiment, the semiconductor device 100 further includes a die carrier 122, wherein a bottom surface of the semiconductor die 102 is attached to the die carrier 122 with an adhesive material. In a preferred embodiment, the die carrier 122 is a substrate. In another preferred embodiment, the die carrier 122 is a tape.

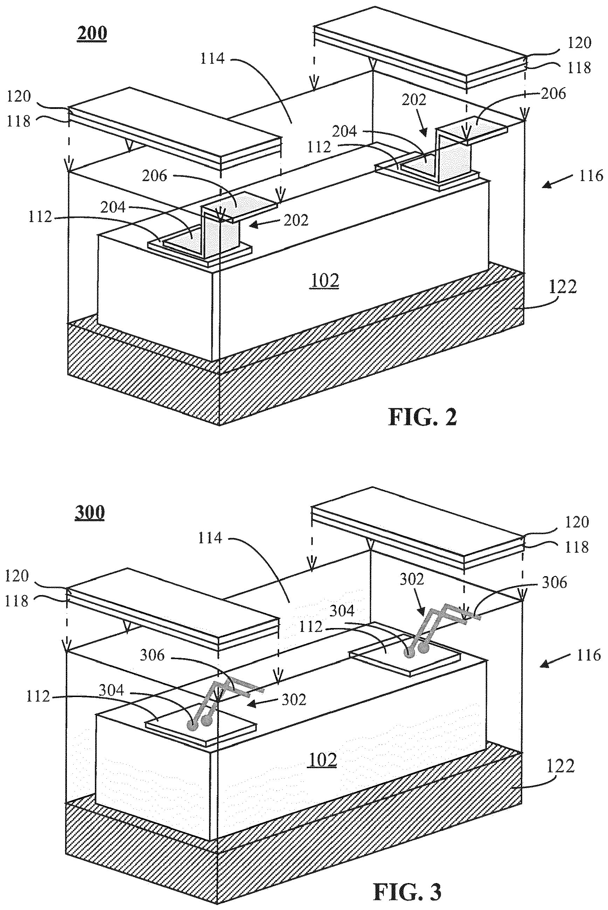

FIG. 2 is a partially exploded isometric view of a leadframe-less surface mount semiconductor device 200 in accordance with a second embodiment of the present invention. The semiconductor device 200 is substantially the same as the semiconductor device 100 except that the electrical connection element 202 is a ribbon-shaped conductive metal clip that has a second end 206 exposed at the top surface of the package body 116 and one side surface of the package body 116.

FIG. 3 is a partially exploded isometric view of a leadframe-less surface mount semiconductor device 300 in accordance with a third embodiment of the present invention. The semiconductor device 300 is substantially the same as the semiconductor device 200 except that the electrical connection element 302 comprises one or more bond wires that have second ends 306 exposed at the top surface of the package body 116 and one side surface of the package body 116.

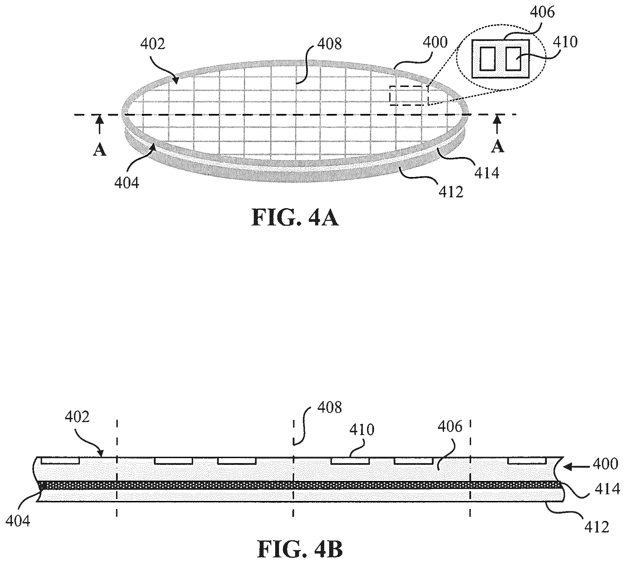

FIGS. 4A-4B, 5A-5B, 6A-6B, 7-8, 9A-9B, 10, 11A-11B and 12-13 are a series of diagrams illustrating steps in assembling a leadframe-less surface mount semiconductor device in accordance with another embodiment of the present invention.

Starting with FIGS. 4A and 4B, a wafer 400 that has a top surface 402 and an opposite bottom surface 404 is provided. FIG. 4A is an isometric view of the wafer 400 and FIG. 4B is a cross-sectional side view of the wafer 400 along line A-A of FIG. 4A. The wafer 400 comprises a plurality of semiconductor dies 406 and has saw streets 408 located between adjacent ones of the dies 406. Each die 406 has one or more bond pads 410 formed on the top surface 402. In a preferred embodiment, each die 400 comprises one or more active components (i.e., internal circuitry not shown) such as transistors or diodes, and the bond pads 410 preferably are formed by depositing a patterned metal layer on the top surface 402. The bond pads 410 provide electrical connections to the active components within the die 406. In a preferred embodiment, the bottom surface 404 of the wafer 400 is mounted on a top surface of a carrier 412 with an adhesive material 414. In a preferred embodiment, the carrier 412 is a semiconductor substrate.

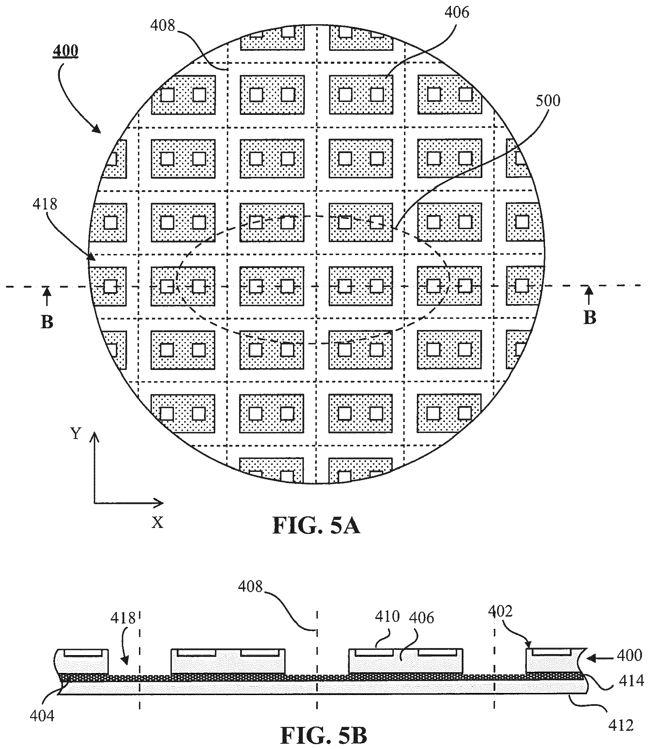

In the next step, illustrated in FIGS. 5A and 5B, the wafer 400 is cut along the saw streets 408 to form a plurality of trenches 418 between adjacent ones of the dies 406. FIG. 5A is a top plan view of the wafer 400 after the cut, and FIG. 5B is a cross-sectional side view of a portion 500 of the wafer 400 along the line B-B of FIG. 5A. As shown in FIG. 5A, the semiconductor dies 406 are arranged in an array extending in both X and Y directions. In a preferred embodiment, the trenches 418 extend down to the adhesive material 414. In another preferred embodiment, the trenches 418 extend beyond the adhesive material 414 and into the carrier 412.

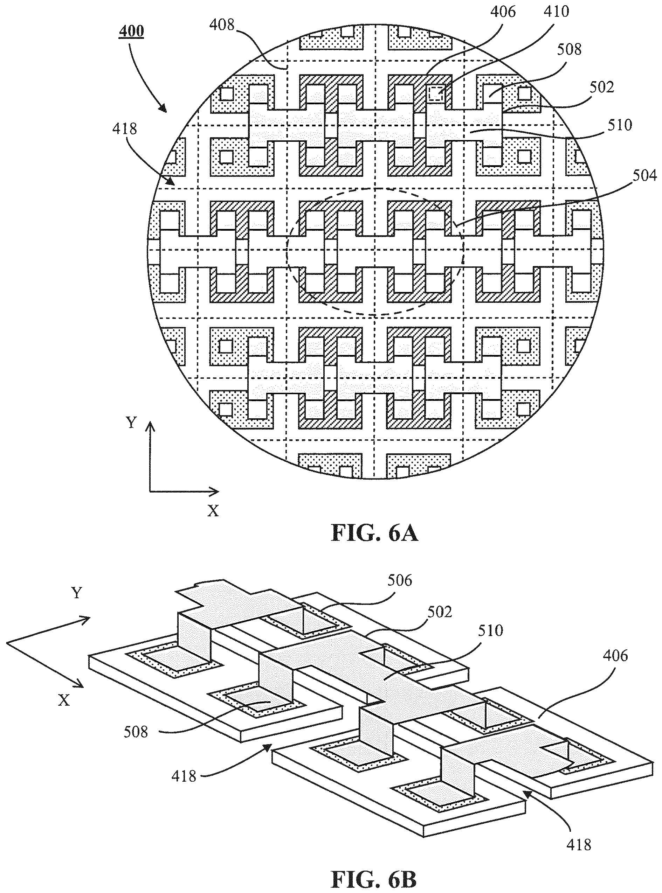

In the next step, illustrated in FIGS. 6A and 6B, a plurality of electrical connection elements 502 are attached or electrically connected to the bond pads 410 of the semiconductor dies 406. The electrical connection elements 502 include feet 508, and each electrical connection element 502 bridges adjacent semiconductor dies 406 in at least one of the X and Y directions. FIG. 6A is a top plan view of the wafer 400 with the electrical connection elements 502 bonded thereto, and FIG. 6B is an enlarged isometric view of a portion 504 of the semiconductor dies 406 and the electrical connection elements 502 that include four semiconductor dies 406 adjacent to an intersection of two perpendicular trenches 418.

In a preferred embodiment, redistribution layers 506 are attached to the bond pads 410, and the electrical connection elements 502 are bonded to the redistribution layers 506 and electrically connected to the bond pads 410 through the redistribution layers 506. The redistribution layers 506 are provided as an option if the bond pad 410 does not have enough area to cater for the feet 508 of the electrical connection elements 502. In a preferred embodiment, the redistribution layers 506 are separate pieces respectively located between the bond pads 410 and the feet 508 of the electrical connection elements 502. In another preferred embodiment, there is a single redistribution layer 506 located over the top surface of the semiconductor die 406.

In a preferred embodiment as shown in FIGS. 6A and 6B, the electrical connection element 502 comprises a metal gang clip that has four feet 508 respectively bonded to bond pads 410 of four semiconductor dies 406 adjacent to an intersection of two perpendicular trenches 418, and a bridge portion 510 connecting the four feet 504, such that the electrical connection elements 502 bridge adjacent semiconductor dies 406 in both the X and Y directions.

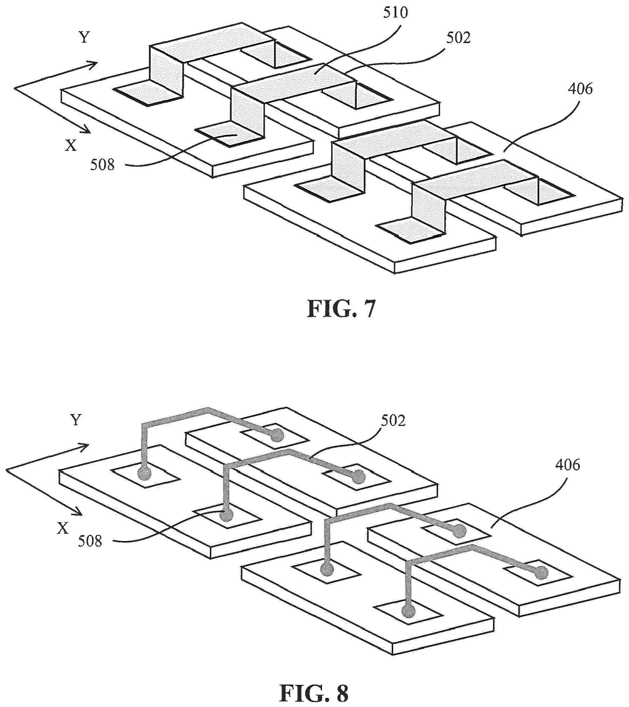

In another preferred embodiment as shown in FIG. 7, the electrical connection element 502 is a ribbon-shaped metal clip that has two feet 508 bonded to bond pads of two adjacent semiconductor dies 406, and the bridge portion 510 connecting the two feet 508, such that electrical connection element 502 bridges the two adjacent semiconductor dies 406 in the Y direction.

In yet another embodiment as shown in FIG. 8, the electrical connection elements 502 comprises bond wires that bridge adjacent semiconductor dies 406 in the Y direction.

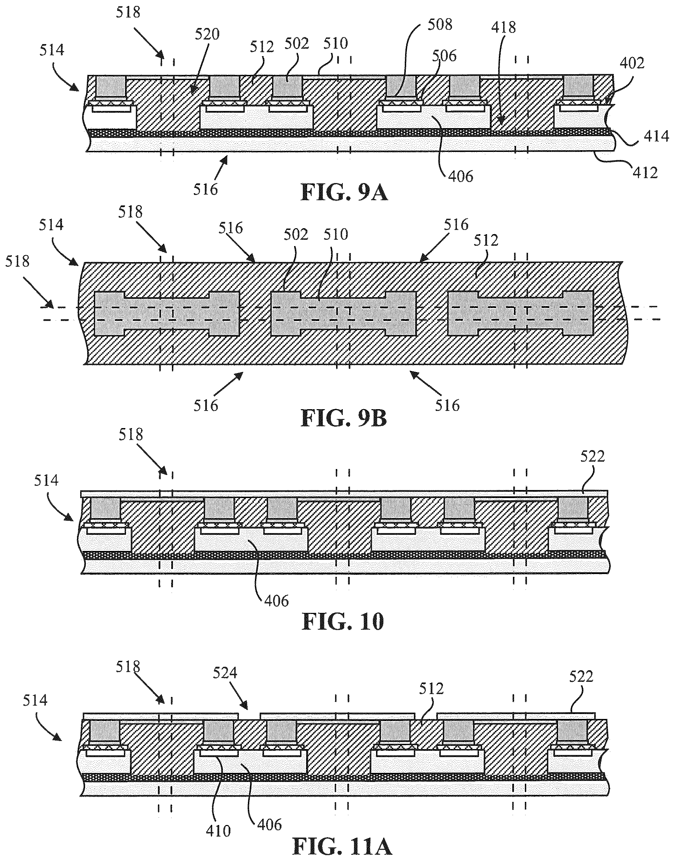

In the next step, illustrated in FIGS. 9A and 9B, the semiconductor dies 406 and the electrical connection elements 502 are encapsulated with a molding material 512 to form an assembly 514 of an array of semiconductor devices 516 separated by saw streets 518. FIGS. 9A and 9B are respectively a cross-sectional side view and a top plan view of the assembly 514. The molding material 512 fills the plurality of trenches 418 and covers side surfaces of the semiconductor dies 406. Each semiconductor device 516 comprises a package body 520 formed by the molding material 512, wherein the bridge portion 510 of the electrical connection elements 502 is exposed at a top surface of the assembly 514.

In the next step, illustrated in FIG. 10, a metal layer 522 is formed over the top surface of the assembly 514. In a preferred embodiment, the metal layer 522 is formed by sputtering or plating. In a preferred embodiment, the metal layer 522 comprises copper.

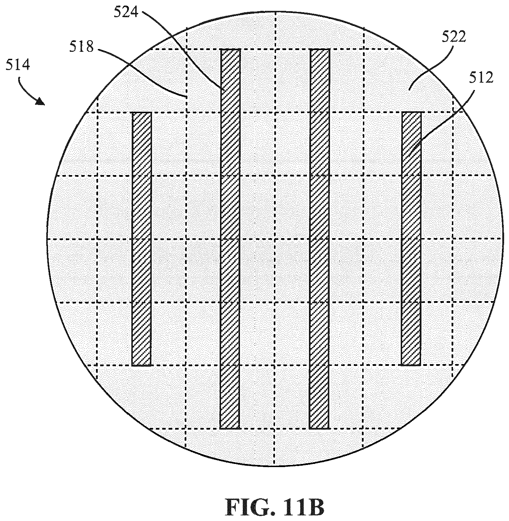

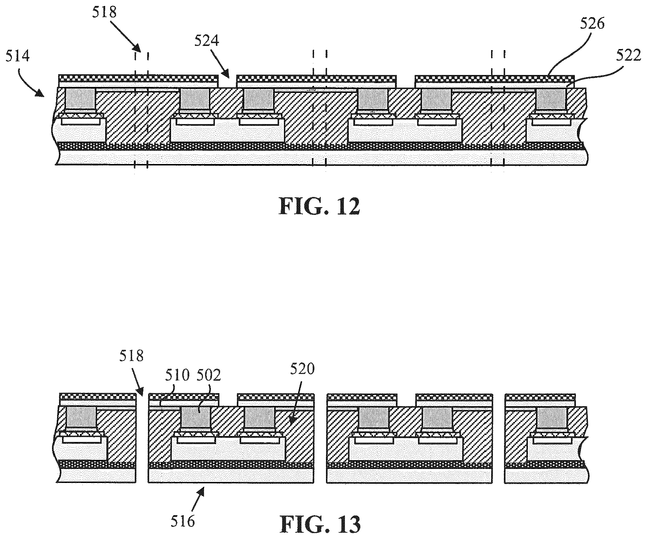

As shown in FIGS. 11A and 11B, openings 524 are selectively formed within the metal layer 522 by chemical etching or mechanical half-cutting to electrically isolate the bond pads 410 of each semiconductor die 406 from each other. FIGS. 11A and 11B respectively show a cross-sectional side view and a top plan view of the assembly 514 after the openings 524 have been formed in the metal layer 522. The molding material 512 is exposed at the openings 524. In a preferred embodiment, the openings 524 are parallel to the saw streets 518 in one direction. In another preferred embodiment, the openings 524 do not extend to the edge of the metal layer 522, such that the metal layer 522 remains one piece of metal and is not split by any of the openings 524. In a preferred embodiment, as shown in FIG. 12, the metal layer 522 is coated with a wettable material 526 such as by by electro-plating. The wettable material 526 may comprise tin or a tin alloy, as is known in the art. In an alternate embodiment, the electro-plating is performed before the openings 524 are formed. In the next step, illustrated in FIG. 13, singulation is performed along the saw streets 518 to separate the semiconductor devices 516 from each other. After singulation, the remaining bridge portion 510 of the electrical connection element 502 is exposed at a top surface and at least one side surface of the package body 520.

In an embodiment semiconductor device, may comprise: a die with at least two bond pads on a top surface thereof; at least two electrically conductive clips having first ends respectively connected to the bond pads; a molding material covering the die and the clips, wherein the mold compound forms a package body and opposite second ends of the clips are exposed at a top surface of the package body and at least one side surface of the package body; and at least two metal layers formed over respective exposed second ends of the clips and the top surface of the package body.

The second ends of the clips may be exposed at the top surface of the package body and two adjacent side surfaces of the package body.

The description of the preferred embodiments of the present invention has been presented for purposes of illustration and description, but is not intended to be exhaustive or to limit the invention to the forms disclosed. It will be appreciated by those skilled in the art that changes could be made to the embodiments described above without departing from the broad inventive concept thereof. It is understood, therefore, that this invention is not limited to the particular embodiment disclosed, but covers modifications within the spirit and scope of the present invention as defined by the appended claims.

## Claims

1. A semiconductor device, comprising:
a semiconductor die having a top surface with one or more bond pads formed thereon, and an opposite bottom surface;
one or more electrical connection elements each having a first end located at a first plane and electrically connected to one of the one or more bond pads, and an opposite second end located at a second plane that is different from the first plane; and
a molding material encapsulating the semiconductor die and the one or more electrical connection elements, wherein the molding material defines a package body that has a top surface and one or more side surfaces, wherein the second end of each electrical connection element is exposed at the top surface and at least one of the one or more side surfaces of the package body.

2. The semiconductor device of claim 1, wherein the second end of each of the one or more electrical connection elements is exposed at the top surface and two adjacent side surfaces of the package body.

3. The semiconductor device of claim 1 or 2, further comprising:
a metal layer formed over the top surface of the package body and electrically connected to at least one of the one or more electrical connection elements.

4. The semiconductor device of claim 3, wherein the metal layer is coated with a wettable material by electrically conductive plating.

5. The semiconductor device of any of claims 1 to 4, further comprising:
a die carrier, wherein the bottom surface of the semiconductor die is attached to the die carrier; and/or
a redistribution layer located between the one or more bond pads and the one or more electrical connection elements.

6. The semiconductor device of any of claims 1 to 5, wherein the one or more electrical connection elements are metal clips; and/or bond wires.

7. A method for assembling a semiconductor device, the method comprising:
providing a wafer that has a top surface and an opposite bottom surface, wherein the wafer comprises a plurality of semiconductor dies arranged in an array that extends in first and second directions, and saw streets located between adjacent ones of the semiconductor dies, wherein each semiconductor die has one or more bond pads formed on the top surface;
bonding one or more electrical connection elements to the bond pads of the semiconductor dies, wherein each electrical connection element bridges adjacent semiconductor dies in at least one of the first and second directions;
encapsulating the semiconductor dies and the one or more electrical connection elements with a molding material to form an assembly of an array of semiconductor devices, wherein each semiconductor device comprises a package body formed by the molding material, and each of the one or more electrical connection elements has a bridge portion exposed at a top surface of the assembly; and
singulating the semiconductor devices by cutting the assembly along the saw streets, wherein a remaining portion of each electrical connection element of each semiconductor device has an end exposed at a top surface and at least one side surface of the package body.

8. The method of claim 7, wherein each electrical connection element bridges adjacent semiconductor dies in both the first and second directions, such that the remaining portion of each electrical connection element of each semiconductor device has an end exposed at the top surface and two adjacent side surfaces of the package body.

9. The method of any of claims 7 or 8, further comprising:
cutting the wafer along the saw streets to form a plurality of trenches between adjacent ones of the dies before said encapsulating, such that after said encapsulating, the molding material fills the plurality of trenches and covers side surfaces of the semiconductor dies.

10. The method of any of claims 7 to 9, further comprising:
forming a metal layer over the top surface of the assembly; and
selectively cutting the metal layer to electrically isolate the electrical connection elements of each semiconductor device from each other.

11. The method of claim 14, wherein the metal layer is formed by sputtering or plating.

12. The method of any of claims 10 or 11, further comprising:
electro-plating the metal layer with a wettable material.

13. The method of any of claims 7 to 12, further comprising:
mounting the bottom surface of the wafer to a top surface of a carrier.

14. The method of any of claims 7 to 13, further comprising:
forming a redistribution layer over the top surface of the wafer before bonding the one or more electrical connection elements to the bond pads of the semiconductor dies.

15. The method of any of claims 7 to 14, wherein the one or more electrical connection elements are metal clips, wherein each metal clip has four feet respectively electrically connected to bond pads of semiconductor dies located at four quarters of an intersection of two saw streets, and a bridge portion connecting the four feet, and/or wherein the one or more electrical connection elements are bond wires.
